# EUROPÄISCHE PATENTSCHRIFT

(11) **EP 1 897 353 B1**
(45) Veröffentlichungstag und Bekanntmachung des Hinweises auf die Patenterteilung: **08.08.2012**
(21) Anmeldenummer: 06763563.1
(22) Anmeldetag: 07.06.2006
(51) Int. Cl.: G01R 27/02, G01R 31/28, H04B 3/46, H04M 3/30

(54) **VERFAHREN UND EINRICHTUNG ZUR BESTIMMUNG DES LECKWIDERSTANDS VON ZUMINDEST EINER ADER EINER MEHRERE ADERN AUFWEISENDEN TEILNEHMERANSCHLUSSLEITUNG IN EINEM KOMMUNIKATIONSNETZ**
METHOD AND DEVICE FOR DETERMINING A LEAK RESISTANCE FOR AT LEAST ONE WIRE OF A SUBSCRIBER CONNECTION LINE COMPRISING SEVERAL WIRES IN A COMMUNICATIONS NETWORK
PROCÉDÉ ET DISPOSITIF POUR DÉTERMINER LA RÉSISTANCE DE FUITE D'AU MOINS UN CONDUCTEUR D'UNE LIGNE DE RACCORDEMENT D'ABONNÉ PRÉSENTANT PLUSIEURS CONDUCTEURS DANS UN RÉSEAU DE COMMUNICATION

(30) Priorität: 23.06.2005 DE 102005029271
(43) Veröffentlichungstag der Anmeldung: 12.03.2008
(73) Patentinhaber: Nokia Siemens Networks GmbH & Co. KG, 81541 München (DE)
(72) Erfinder: DOLLINGER, Rudolf, 81243 München (DE)
(86) Internationale Anmeldenummer: PCT/EP2006/062974
(87) Internationale Veröffentlichungsnummer: WO 2006/136494

(56) Entgegenhaltungen:
- EP-A- 0 052 220
- EP-A- 0 762 713
- DE-A1- 4 125 883
- US-A- 5 073 920

## Beschreibung

Die Erfindung betrifft ein Verfahren und eine Einrichtung zur Bestimmung des Leckwiderstands von zumindest einer Ader einer mehrere Adern aufweisenden Teilnehmeranschlussleitung in einem Kommunikationsnetz:

Die Betreiber von Kommunikationsnetzen wie beispielsweise dem herkömmlichen Telefonnetz bzw. Fernsprechnetz stellen den Teilnehmern oder Kunden neben der Nutzdatenübermittlung (im Telefonnetz: der Sprache) oftmals eine Vielzahl an weiteren Leistungen bzw. Teilnehmerleistungsmerkmalen zur Verfügung. Zu diesen Leistungen gehören z.B. Konferenzschaltungen, die Übertragung bzw. Unterdrückung von Rufnummern, die Anrufweiterleitung oder der Gebührenimpuls.

Bei Beschwerden.der Teilnehmer oder auch bei einer routinemäßigen Überprüfung oder Kontrolle dieser zugesicherten Leistungen müssen unter anderem die elektrischen Eigenschaften der Teilnehmeranschlussleitungen (TAL) vom Betreiber des Fernsprechnetzes gemessen werden. Bei einer derartigen Messung dürfen angeschlossene Endgeräte jedoch nicht hörbar ansprechen.

Zwei der wichtigsten elektrischen Parameter der Teilnehmeranschlussleitung sind der ohmsche Leckwiderstand zwischen Leitung und Erde sowie der so genannte Leitungsbelag, die Kapazität zwischen Leitung und Erde.

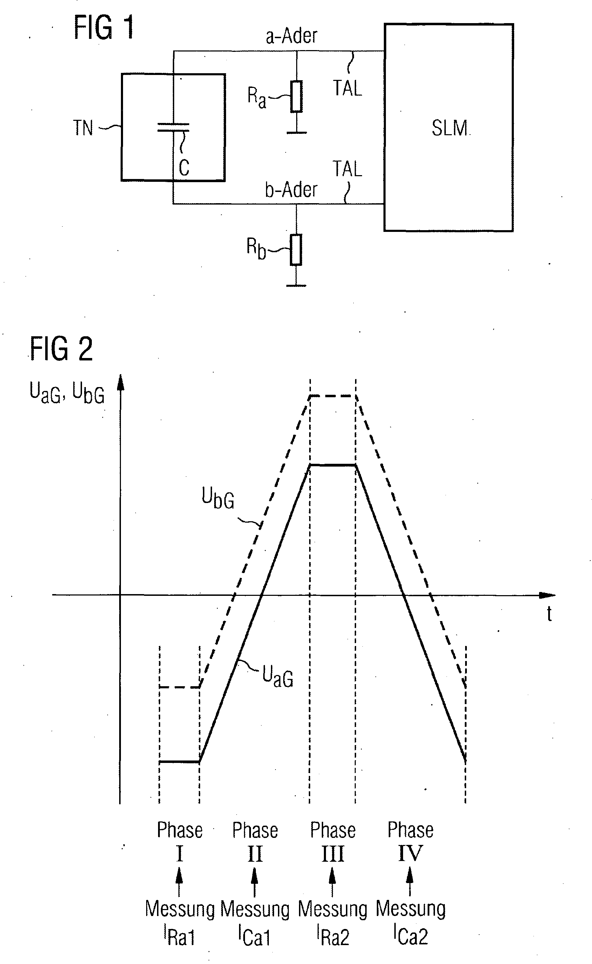

Fig. 1 zeigt nun beispielhaft den prinzipiellen, schematischen Aufbau eines aktuellen analogen Teilnehmeranschlusses eines Fernsprech- bzw. Telefonnetzes.

Die jeweiligen Teilnehmer TN sind dabei über die entsprechende Teilnehmeranschlussleitung TAL mit einer der Vermittlungseinrichtung zugeordneten Teilnehmeranschlussbaugruppe SLM ("subscriber line module") verbunden. Die Anschlussleitung TAL selbst besteht üblicherweise aus herkömmlichen Kupfer-Doppeladern, wobei die beiden Anschlüsse als a-Ader bzw. b-Ader bezeichnet werden.

Das an die Teilnehmeranschlussleitung TAL angeschlossene Endgerät entspricht schaltungstechnisch bei nahezu allen Endgeräten einer zwischen die Enden der a-Ader und der b-Ader geschalteten Kapazität C. Diese Kapazität C wird auch als Wecker-Kapazität bezeichnet, da es sich dabei um die Komponente des Endgeräts handelt, die die von der Vermittlungsstelle bei einem ankommenden Anruf auf die Teilnehmeranschlussleitung TAL aufgelegte Wechselspannung erfasst, die also den ankommenden Anruf erkennt.

Des Weiteren sind in Fig. 1 zwei Leckwiderstände Rₐ und R_{b} dargestellt, die die Verbindungen für die Leckströme zwischen den beiden Adern a und b der Teilnehmeranschlussleitung und der Erde repräsentieren.

Ein Verfahren zur Ausmessung einer Teilnehmeranschlussleitung ist beispielsweise in dem US-Patent US5073920 offenbart. Darin wird ein Verfahren vorgestellt, mit dem die Impedanz einer Telefonanschlussleitung untersucht werden kann.

Bei einem dem Stand der Technik zuzuordnenden Verfahren zur Bestimmung dieser Leckwiderstände Rₐ und R_{b} und des Leitungsbelags ("RC-Messung") ergibt sich nun ein Problem: die Weckerkapazität C verfälscht bei dem aktuellen Verfahren die gemessenen Werte der Leckströme auf den Adern (a und b) der Teilnehmeranschlussleitung TAL.

Dieses Messverfahren nach dem Stand der Technik wird im Folgenden unter Verweis auf Fig. 2 beschrieben.

Fig. 2 stellt beispielhaft den zeitlichen Ablauf eines Verfahrens zur Bestimmung von sowohl dem Widerstand zwischen Leitung und Erde als auch der Kapazität zwischen Leitung und Erde auf der a-Ader einer Teilnehmeranschlussleitung eines analogen Fernsprechanschlusses dar.

Bei einer RC-Messung der a-Ader wird die zweite Ader b zu Beginn hochohmig geschaltet. Anschließend wird an die auszumessende Leitungsader a eine Spannung mit dem in Fig. 2 gezeigten zeitlichen Verlauf aufgelegt.

Dabei wird zuerst eine konstante (in diesem Beispiel negative) Spannung U_{aG} an die a-Ader angelegt. Während dieser Phase (I) wird der ohmsche Leckstrom I_{Ra1} zwischen Ader a und Erde gemessen.

Im Anschluss daran wird eine konstant steigende Spannung U_{aG} an die a-Ader angelegt (Phase II). Während dieser zweiten Phase wird nun der Verlauf des kapazitiven Stroms I_{Ca1} gemessen. Dabei steigt während der Messung die an die b-Ader angelegte Spannung U_{aG} vom negativen Bereich konstant bis auf einen vorgebbaren positiven Wert an.

Nach dem Erreichen dieses Maximalwerts wird die Spannung U_{aG} anschließend konstant gehalten (Phase III). Auch während der dritten Phase wird nun der ohmsche Leckstrom gemessen. Es ergibt sich somit ein zweiter Wert für den Leckstrom, in diesem Fall bezeichnet mit I_{Ra2}.

Zum Abschluss der Messung wird in Phase IV die angelegte Spannung U_{aG} konstant verringert. Dabei wird ein zweites Mal der Stromverlauf des kapazitiven Stroms der Teilnehmeranschlussleitung gemessen, hier bezeichnet mit I_{Ca2}. Die Spannung U_{aG} nimmt dabei ausgehend von dem vorgebbaren positiven Wert bis zu einem vorherbestimmten negativen Wert ab.

Aus diesen vier während der Messung erfassten Werten I_{Ra1}, I_{Ra2}, I_{Ca1} und I_{Ca2} können anschließen Leckwiderstand und Leitungsbelag der a-Ader der Teilnehmeranschlussleitung bestimmt werden. Zur Bestimmung der entsprechenden Werte für die zweite Ader b der Teilnehmeranschlussleitung werden die oben beschriebenen Schritte mit entsprechend vertauschten Ausgangspositionen durchgeführt.

Nachteilig an dem soeben beschriebenen Verfahren zur RC-Messung ist dabei, wie oben bereits erwähnt, die Tatsache, dass die zwischen den beiden Adern a und b angeordnete Weckerkapazität die Werte für I_{Ra1} bzw. I_{Ra2} verfälscht.

Der Erfindung liegt die Aufgabe zugrunde, das Verfahren zur Bestimmung des Leckwiderstands von zumindest einer Ader einer mehrere Adern aufweisenden Teilnehmeranschlussleitung in einem Kommunikationsnetz zu verbessern. Diese Aufgabe wird ausgehend von einem Verfahren gemäß den Merkmalen des Oberbegriffs des Patentanspruchs 1 durch dessen kennzeichnende Merkmale sowie ausgehend von einer Einrichtung gemäß den Merkmalen des Oberbegriffs des **Patentanspruchs 10** durch dessen kennzeichnende Merkmale gelöst.

Beim erfindungsgemäßen Verfahren zur Bestimmung des Leckwiderstands von zumindest einer Ader einer mehrere Adern aufweisenden Teilnehmeranschlussleitung in einem Kommunikationsnetz wird vor der Bestimmung des Leckwiderstands der zumindest einen Ader eine zwischen der zumindest einen Ader und einer weiteren Ader anordenbare Kapazität entladen.

Vorteilhaft wird die Kapazität durch das Anlegen einer abfallenden Spannung an die zumindest eine Ader und das Anlegen einer steigenden Spannung an die weitere Ader sowie das anschließende Hochohmigschalten der weiteren Ader entladen.

Dabei werden die Endwerte der abfallenden Spannung und der steigenden Spannung vorteilhaft so gewählt, dass die Spannung auf der weiteren Ader nach dem Hochohmigschalten der weiteren Ader 0 Volt beträgt - **Anspruch 2**.

Gemäß einer weiteren vorteilhaften Ausführungsform der Erfindung erfolgt die Bestimmung des Leckwiderstands der zumindest einen Ader nach dem Hochohmigschalten der weiteren Ader - **Anspruch 3.**

Zudem erfolgt die Bestimmung des Leckwiderstands vorteilhaft durch zumindest eine Messung des Leckstroms auf der einen Ader der Teilnehmeranschlussleitung, wobei die zumindest eine Messung des Leckstroms vorteilhaft bei einer konstanten angelegten Spannung erfolgt - **Ansprüche 4 und 5**.

Vorteilhaft erfolgen ferner zwei Messungen des Leckstroms, wobei vor der zweiten Messung die Kapazität erneut entladen wird - **Anspruch 6**.

Weitere vorteilhafte Ausführungsformen sowie eine Einrichtung zur Bestimmung des Leckwiderstands von zumindest einer Ader einer mehrere Adern aufweisenden Teilnehmeranschlussleitung in einem Kommunikationsnetz sind den weiteren Ansprüchen zu entnehmen.

Mit Hilfe der beigefügten Zeichnungen wird die Erfindung detaillierter erläutert. Dabei zeigen:
Fig. 1 den prinzipiellen, schematischen Aufbau eines aktuellen analogen Teilnehmeranschlusses eines Fernsprech- bzw. Telefonnetzes,
Fig. 2 den zeitlichen Ablauf eines Verfahrens zur Bestimmung des Leckwiderstands sowie des Leitungsbelags auf der a-Ader einer Teilnehmeranschlussleitung gemäß dem Stand der Technik, und
Fig. 3 den zeitlichen Ablauf des erfindungsgemäßen Verfahrens zur Bestimmung des Leckwiderstands, wobei bei diesem Beispiel zusätzlich der Leitungsbelag auf der a-Ader nach einem herkömmlichen Verfahren einer Teilnehmeranschlussleitung bestimmt wird.

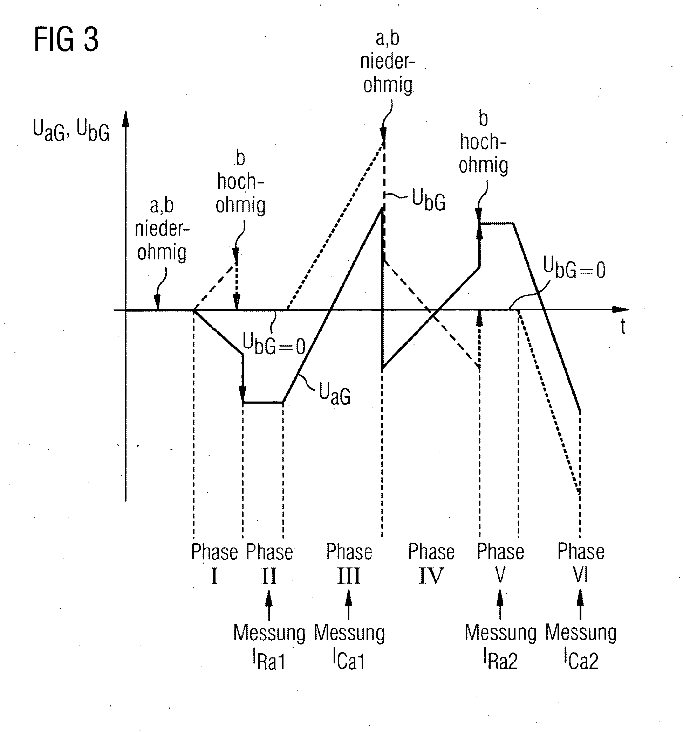

In Fig. 3 ist der zeitliche Ablauf des Verfahrens zur Bestimmung des Widerstands zwischen Ader und Erde einer Teilnehmeranschlussleitung gemäß der Erfindung dargestellt. Das Verfahren wird dabei beispielhaft anhand einer kombinierten Bestimmung von Leckwiderstand und Leitungsbelag ("RC-Messung") der a-Ader einer zwei Adern (a und b) umfassenden Teilnehmeranschlussleitung beschrieben.

Beim erfindungsgemäßen Verfahren sind zu Beginn sowohl a-Ader als auch b-Ader der Teilnehmeranschlussleitung niederohmig geschaltet. Im ersten Schritt (Phase I) wird an die auszumessende Ader a eine konstant abfallende Spannung U_{aG} (durch eine durchgezogene Linie verdeutlicht) angelegt, wodurch bedingt durch die Kopplung der beiden Adern a und b gleichzeitig die Spannung U_{bG} (durch eine strichlierte Linie verdeutlicht) auf der zweiten Ader b einen entsprechenden, konstant steigenden Verlauf aufweist. Die beiden Spannungen U_{aG} bzw. U_{bG} erreichen dabei jeweils einen vorgebbaren Endwert.

Zu Beginn von Phase II wird nun Ader b hochohmig geschaltet. Durch eine geeignete Wahl der im ersten Schritt eingestellten End- bzw. Zielspannungen fällt durch dieses Hochohmigschalten der b-Ader die Spannung U_{bG} (b-Ader gegen Erde) auf 0 Volt, wodurch Kapazität C entladen wird. Zeitgleich erfolgt ein entsprechender Abfall der Spannung U_{aG} (a-Ader gegen Erde) auf ein tieferes, negatives Niveau. Die Spannung U_{aG} wird anschließend konstant auf dem besagten Niveau gehalten, und es erfolgt eine erste Messung des ohmschen Stroms auf der a-Ader: I_{Ra1}.

Nach Abschluss dieser Messung wird an Ader a eine konstant steigende Spannung angelegt (Phase III) bis die Spannung U_{aG} einen vorgebbaren positiven Wert erreicht hat. Während dieser Spannungszunahme auf Ader a wird der Verlauf des kapazitiven Stroms I_{Ca1} auf dieser Ader gemessen. Durch die zunehmende Spannung auf der a-Ader nimmt, wie in Fig. 3 dargestellt, zugleich die Spannung U_{bG} zwischen b-Ader und Erde zu (gestrichelte Linie).

Nach Abschluss der Messung von I_{Ca1} und nach dem Erreichen der Maximalspannung wird zu Beginn von Phase IV die b-Ader der Teilnehmeranschlussleitung wieder niederohmig geschaltet. Durch das Niederohmigschalten wird zum einen Ader b auf ein tieferes Spannungsniveau gezogen, während zum anderen U_{aG} ebenfalls fällt. In diesem Fall fällt die Spannung zwischen Ader und Erde (U_{aG}) bis auf einen negativen Spannungswert.

Anschließend wird gemäß dem beispielhaften Verfahren für eine zweite Messung des Leckstroms so vorgegangen wie in Phase I - allerdings mit entgegengesetzten Vorzeichen. D.h. in Phase IV wird an Ader a eine konstant steigende Spannung angelegt, wodurch Ader b gleichzeitig mit einer konstant fallenden Spannung versorgt wird. Beide Spannungen U_{aG} und U_{bG} durchlaufen dabei in diesem Beispiel den Nullpunkt und erreichen schließlich als Endspannungen jeweils einen vorgebbaren Zielwert.

In Phase V wird Ader b nun wieder hochohmig geschaltet. Eine geeignete Einstellung der End- bzw. Spitzenspannungen von U_{aG} und U_{bG} in Phase IV führt dazu, dass die Spannung b-Ader gegen Erde U_{bG} erneut auf 0 Volt gezogen wird. Spannung U_{aG} (Spannung zwischen a-Ader und Erde) steigt gleichzeitig auf einen entsprechend höheren Wert. Im Anschluss an dieses erneute Hochohmigschalten der b-Ader wird die Spannung U_{aG} konstant gehalten und eine zweite Messung des ohmschen Stroms I_{Ra2} durchgeführt. Auch bei dieser zweiten Messung gilt: U_{bG} = 0 Volt.

Abschließend wird in Phase VI an Ader a eine konstant fallende Spannung angelegt. Während dieser Phase wird eine zweite Messung des kapazitiven Stroms I_{Ca2} auf der a Ader durchgeführt, während die Spannung a-Ader gegen Erde U_{aG} bis auf einen vorgebbaren negativen Wert abnimmt.

Nach Ablauf des erfindungsgemäßen Verfahrens können aus den erfassten Messwerten I_{Ra1}, I_{Ca1}, I_{Ra2} und I_{Ca2} die Werte für den Leckwiderstand sowie den Leitungsbelag der a-Ader der Teilnehmeranschlussleitung auf herkömmliche Weise bestimmt werden. Wie oben erwähnt, ergeben sich bei diesem erfindungsgemäßen Verfahren keine fehlerhaften Messungen der ohmschen Ströme I_{Ra1} bzw. I_{Ra2}, da die Weckerkapazität C jeweils vor der Messung der Ströme entladen wird.

Um die Werte für die b-Ader zu bestimmen, um also eine entsprechende RC-Messung der b-Ader durchzuführen, kann das erfindungsgemäße Verfahren auch entsprechend auf der zweiten Ader b der Teilnehmeranschlussleitung eingesetzt werden.

## Patentansprüche

1. Verfahren zur Bestimmung des Leckwiderstands (Rₐ, R_{b}) von zumindest einer Ader (a) einer mehrere Adern (a, b) aufweisenden Teilnehmeranschlussleitung (TAL) in einem Kommunikationsnetz, wobei
vor der Bestimmung des Leckwiderstands (Rₐ, R_{b}) der zumindest einen Ader (a) eine zwischen der zumindest einen Ader (a) und einer weiteren Ader (b) anordenbare Kapazität (C) entladen wird,
**dadurch gekennzeichnet,**
**dass** die Kapazität (C) durch das Anlegen einer abfallenden Spannung (U_{aG}) an die zumindest eine Ader (a) und das Anlegen einer steigenden Spannung (U_{bG}) an die weitere Ader (b) sowie durch das anschließende Hochohmigschalten der weiteren Ader (b) entladen wird.

2. Verfahren nach Anspruch 1,
**dadurch gekennzeichnet,**
**dass** die Endwerte der abfallende Spannung (U_{aG}) und der steigenden Spannung (U_{bG}) so gewählt werden, dass die Spannung (U_{bG}) auf der weiteren Ader (b) nach dem Hochohmigschalten der weiteren Ader (b) 0 Volt beträgt.

3. Verfahren nach Anspruch 1 oder 2,
**dadurch gekennzeichnet,**
**dass** die Bestimmung des Leckwiderstands (Rₐ, R_{b}) der zumindest einen Ader (a) nach dem Hochohmigschalten der weiteren Ader (b) erfolgt.

4. Verfahren nach einem der vorhergehenden Ansprüche,
**dadurch gekennzeichnet,**
**dass** die Bestimmung des Leckwiderstands (Rₐ, R_{b}) durch zumindest eine Messung des Leckstroms (I_{Ra1}) auf der einen Ader (a) der Teilnehmeranschlussleitung (TAL) erfolgt.

5. Verfahren nach Anspruch 4,
**dadurch gekennzeichnet,**
**dass** die zumindest eine Messung des Leckstroms (I_{Ra1}) bei einer konstanten angelegten Spannung (U_{aG}) erfolgt.

6. Verfahren nach Anspruch 5,
**dadurch gekennzeichnet,**
**dass** zwei Messungen des Leckstroms (I_{Ra1}, I_{Ra2}) erfolgen, wobei vor der zweiten Messung die Kapazität (C) erneut entladen wird.

7. Verfahren nach Anspruch 6,
**dadurch gekennzeichnet,**
**dass** das erneute Entladen der Kapazität (C) vor der zweiten Messung durch das Anlegen einer steigenden Spannung (U_{aG}) an die zumindest eine Ader (a) und das Anlegen einer abfallenden Spannung (U_{aG}) an die weitere Ader (b) sowie durch das Hochohmigschalten der zweiten Ader (b) erfolgt.

8. Verfahren nach Anspruch 7,
**dadurch gekennzeichnet,**
**dass** die Endwerte der steigenden Spannung (U_{aG}) und der abfallenden Spannung (U_{bG}) so gewählt werden, dass die Spannung (U_{bG}) auf der weiteren Ader (b) nach dem Hochohmigschalten der weiteren Ader (b) 0 Volt beträgt.

9. Verfahren nach einem der vorhergehenden Ansprüche,
**dadurch gekennzeichnet,**
**dass** die Bestimmung des Leckwiderstands (Rₐ, R_{b}) im Rahmen einer Bestimmung von Leckwiderstand und Leitungsbelag der Teilnehmeranschlussleitung (TAL) durchgeführt wird.

10. Einrichtung zur Bestimmung des Leckwiderstands (Rₐ, R_{b}) von zumindest einer Ader (a) einer mehrere Adern (a, b) aufweisenden, anschließbaren Teilnehmeranschlussleitung (TAL) in einem Kommunikationsnetz mit Mitteln zum Anlegen einer Spannung (U_{aG}), wobei
die Mittel zum Anlegen einer Spannung (U_{aG}) derart ausgestaltet sind, dass vor der Bestimmung des Leckwiderstands (Rₐ, R_{b}) der zumindest einen Ader (a) eine zwischen der zumindest einen Ader (a) und einer weiteren Ader (b) anordenbare Kapazität (C) entladen wird,
**dadurch gekennzeichnet**
**dass** die Mittel zum Anlegen einer Spannung (U_{aG}, U_{bG}) derart ausgestaltet sind, dass die Kapazität durch das Anlegen einer abfallenden Spannung (U_{aG}) an die zumindest eine Ader (a) und das Anlegen einer steigenden Spannung (U_{aG}) an die weitere Ader (b) sowie das anschließende Hochohmigschalten der weiteren Ader (b) entladen wird.

11. Einrichtung nach Anspruch 10,
**dadurch gekennzeichnet,**
**dass** die Mittel zum Anlegen einer Spannung (U_{aG}, U_{bG}) derart ausgestaltet sind, dass die Endwerte der abfallenden Spannung (U_{aG}) und der steigenden Spannung (U_{bG}) so gewählt werden, dass die Spannung (U_{bG}) auf der weiteren Ader (b) nach dem Hochohmigschalten der weiteren Ader (b) 0 Volt beträgt.

12. Einrichtung nach einem der Ansprüche 10 oder 11,
**dadurch gekennzeichnet,**
**dass** eine Strommesseinrichtung vorgesehen ist, die so ausgestaltet ist, dass zur Bestimmung des Leckwiderstands (Rₐ, R_{b}) wenigsten einmal der Leckstrom (I_{Ra1}, I_{Ra2}) auf der einen Ader (a) der Teilnehmeranschlussleitung (TAL) gemessen wird.

## Claims

1. Method for determining the leakage resistance (Rₐ, R_{b}) of at least one wire (a) of a subscriber line (TAL) having a number of wires (a, b) in a communication network, wherein before the determination of the leakage resistance (Rₐ, R_{b}) of the at least one wire (a), a capacitance (C) which can be arranged between the at least one wire (a) and a further wire (b) is discharged, **characterized in that** the capacitance (C) is discharged by applying a decreasing voltage (U_{aG}) to the at least one wire (a) and applying a rising voltage (U_{bG}) to the further wire (b) and by subsequently switching the further wire (b) to high impedance.

2. Method according to Claim 1, **characterized in that** the final values of the decreasing voltage (U_{aG}) and of the rising voltage (U_{bG}) are selected in such a manner that the voltage (U_{bG}) on the further wire (b) is 0 volts after the further wire (b) has been switched to high impedance.

3. Method according to Claim 1 or 2, **characterized in that** the leakage resistance (Rₐ, R_{b}) of the at least one wire (a) is determined after the further wire (b) has been switched to high impedance.

4. Method according to one of the preceding claims, **characterized in that** the leakage resistance (Rₐ, R_{b}) is determined by at least one measurement of the leakage current (I_{Ra1}) on the one wire (a) of the subscriber line (TAL).

5. Method according to Claim 4, **characterized in that** the at least one measurement of the leakage current (I_{Ra1}) is performed with a constant applied voltage (U_{aG}).

6. Method according to Claim 5, **characterized in that** two measurements of the leakage current (I_{Ra1}, I_{Ra2}) are performed, the capacitance (C) being discharged again before the second measurement.

7. Method according to Claim 6, **characterized in that** the capacitance (C) is discharged again before the second measurement by applying a rising voltage (U_{aG}) to the at least one wire (a) and applying a decreasing voltage (U_{aG}) to the further wire (b) and switching the second wire (b) to high impedance.

8. Method according to Claim 7, **characterized in that** the final values of the rising voltage (U_{aG}) and of the falling voltage (U_{bG}) are selected in such a manner that the voltage (U_{bG}) on the further wire (b) is 0 volts after the further wire (b) has been switched to high impedance.

9. Method according to one of the preceding claims, **characterized in that** the leakage resistance (Rₐ, R_{b}) is determined as part of a determination of leakage resistance and transmission-line constant of the subscriber line (TAL).

10. Device for determining the leakage resistance (Rₐ, R_{b}) of at least one wire (a) of a connectable subscriber line (TAL) having a number of wires (a, b) in a communication network with means for applying a voltage (U_{aG}), wherein the means for applying a voltage (U_{aG}) are arranged in such a manner that before the determination of the leakage resistance (Rₐ, R_{b}) of the at least one wire (a), a capacitance (C) which can be arranged between the at least one wire (a) and a further wire (b) is discharged, **characterized in that** the means for applying a voltage (U_{aG}, U_{bG}) are arranged in such a manner that the capacitance is discharged by applying a decreasing voltage (U_{aG}) to the at least one wire (a) and applying a rising voltage (U_{aG}) to the further wire (b) and subsequently switching the further wire (b) to high impedance.

11. Device according to Claim 10, **characterized in that** the means for applying a voltage (U_{aG}, U_{bG}) are arranged in such a manner that the final values of the decreasing voltage (U_{aG}) and of the rising voltage (U_{bG}) are selected in such a manner that the voltage (U_{bG}) on the further wire (b) is 0 volts after the further wire (b) has been switched to high impedance.

12. Device according to one of Claims 10 or 11, **characterized in that** a current measuring device is provided which is arranged in such a manner that, for determining the leakage resistance (Rₐ, R_{b}), the leakage current (I_{Ra1}, I_{Ra2}) on the one wire (a) of the subscriber line (TAL) is measured at least once.

## Revendications

1. Procédé pour déterminer la résistance de fuite (Rₐ, R_{b}) d'au moins un conducteur (a) d'une ligne de raccordement d'abonné (TAL) comportant plusieurs conducteurs (a, b) dans un réseau de communication, une capacité (C) qui peut être disposée entre
l'au moins un conducteur (a) et un autre conducteur (b) étant déchargée avant la détermination de la résistance de fuite (Rₐ, R_{b}) de l'au moins un conducteur (a),
**caractérisé en ce que**
la capacité (C) est déchargée par application d'une tension descendante (U_{aG}) à l'au moins un conducteur (a) et l'application d'une tension montante (U_{bG}) à l'autre conducteur (b) ainsi que par commutation de l'autre conducteur (b) sur une valeur ohmique élevée.

2. Procédé selon la revendication 1,
**caractérisé en ce que**
les valeurs finales de la tension descendante (U_{aG}) et de la tension montante (U_{bG}) sont choisies de manière telle que la tension (U_{bG}) sur l'autre conducteur (b) après la commutation de l'autre conducteur (b) sur une valeur ohmique élevée est de 0 volt.

3. Procédé selon la revendication 1 ou 2,
**caractérisé en ce que**
la détermination de la résistance de fuite (Rₐ, R_{b}) de l'au moins un conducteur (a) s'effectue après la commutation de l'autre conducteur (b) sur une valeur ohmique élevée.

4. Procédé selon l'une des revendications précédentes,,
**caractérisé en ce que**
la détermination de la résistance de fuite (Rₐ, R_{b}) est effectuée par au moins une mesure du courant de fuite (I_{Ra1}) sur l'un conducteur (a) de la ligne de raccordement d'abonné (TAL).

5. Procédé selon la revendication 4,
**caractérisé en ce que**
l'au moins une mesure du courant de fuite (I_{Ra1}) s'effectue à une tension appliquée constante (U_{aG}).

6. Procédé selon la revendication 5,
**caractérisé en ce que**
deux mesures du courant de fuite (I_{Ra1}, I_{Ra2}) sont effectuées, la capacité (C) étant de nouveau déchargée avant la deuxième mesure.

7. Procédé selon la revendication 6,
**caractérisé en ce que**
le nouveau déchargement de la capacité (C) avant la deuxième mesure s'effectue par application d'une tension montante (U_{aG}) à l'au moins un conducteur (a) et application d'une tension descendante (U_{aG}) à l'autre conducteur (b) ainsi que par commutation du deuxième conducteur (b) sur une valeur ohmique élevée.

8. Procédé selon la revendication 7,
**caractérisé en ce que**
les valeurs finales de la tension montante (U_{aG}) et de la tension descendante (U_{bG}) sont choisies de manière telle que la tension (U_{bG}) sur l'autre conducteur (b) après la commutation de l'autre conducteur (b) sur une valeur ohmique élevée est de 0 volt.

9. Procédé selon l'une des revendications précédentes,
**caractérisé en ce que**
la détermination de la résistance de fuite (Rₐ, R_{b}) est effectuée dans le cadre d'une détermination de la résistance de fuite et de la constante de propagation de la ligne de raccordement d'abonné (TAL).

10. Dispositif pour déterminer la résistance de fuite (Rₐ, R_{b}) d'au moins un conducteur (a) d'une ligne de raccordement d'abonné (TAL) raccordable présentant plusieurs conducteurs (a, b) dans un réseau de communication avec des moyens permettant d'appliquer une tension (U_{aG}),
les moyens permettant d'appliquer une tension (U_{aG}) étant réalisés de manière telle que, avant la détermination de la résistance de fuite (Rₐ, R_{b}) de l'au moins un conducteur (a), une capacité (C) pouvant être disposée entre l'au moins un conducteur (a) et un autre conducteur (b) est déchargée, **caractérisé en ce que**
les moyens permettant d'appliquer une tension (U_{aG}, U_{bG}) sont réalisés de manière telle que la capacité est déchargée par application d'une tension descendante (U_{aG}) à l'au moins un conducteur (a) et application d'une tension montante (U_{aG}) à l'autre conducteur (b) ainsi que par commutation subséquente de l'autre conducteur (b) sur une valeur ohmique élevée.

11. Dispositif selon la revendication 10,
**caractérisé en ce que**
les moyens permettant d'appliquer une tension (U_{aG}, U_{bG}) sont réalisés de manière telle que les valeurs finales de la tension descendante (U_{aG}) et de la tension montante (U_{bG}) sont choisies de manière telle que la tension (U_{bG}) sur l'autre conducteur (b) après la commutation de l'autre conducteur (b) sur une valeur ohmique élevée est de 0 volt.

12. Dispositif selon l'une des revendications 10 ou 11,
**caractérisé en ce que**
est prévu un dispositif de mesure du courant qui est réalisé de manière telle que, pour déterminer la résistance de fuite (Rₐ, R_{b}), le courant de fuite (I_{Ra1}, I_{Ra2}) sur l'un conducteur (a) de la ligne de raccordement d'abonné (TAL) est mesuré au moins une fois.
